Europäisches Patentamt

European Patent Office

Office européen des brevets

(19)

(11) **EP 0 944 916 B1**

(12) **FASCICULE DE BREVET EUROPEEN**

(45) Date de publication et mention
de la délivrance du brevet:
**26.03.2003 Bulletin 2003/13**

(21) Numéro de dépôt: **97951334.8**

(22) Date de dépôt: **15.12.1997**

(51) Int Cl.[7]: **H01L 21/04**

(86) Numéro de dépôt international:
**PCT/FR97/02298**

(87) Numéro de publication internationale:
**WO 98/027578 (25.06.1998 Gazette 1998/25)**

(54) **FILS ATOMIQUES DE GRANDE LONGUEUR ET DE GANDE STABILITE ET PROCEDE DE FABRICATION DE CES FILS**

ATOMARE DRÄHTE VON GROSSER LÄNGE UND STABILITÄT UND VERFAHREN ZUM
HERSTELLEN DIESER DRÄHTE

VERY LONG AND HIGHLY STABLE ATOMIC WIRES AND METHOD FOR MAKING THESE WIRES

(84) Etats contractants désignés:
**AT BE CH DE DK FI GB IT LI NL SE**

(30) Priorité: **16.12.1996 FR 9615435**

(43) Date de publication de la demande:
**29.09.1999 Bulletin 1999/39**

(73) Titulaires:
- **COMMISSARIAT A L'ENERGIE ATOMIQUE**
  **75015 Paris (FR)**
- **CENTRE NATIONAL DE**
  **LA RECHERCHE SCIENTIFIQUE**
  **75016 Paris Cédex (FR)**

(72) Inventeurs:
- **DUJARDIN, Gérald**
  **F-92290 Chatenay Malabry (FR)**
- **MAYNE, Andrew**
  **F-92160 ANTONY FRANCE (FR)**
- **SEMOND, Fabrice**
  **06250 MOUGINS LE HAUT (FR)**
- **SOUKIASSIAN, Patrick**
  **F-78470 Saint Remy lès Chevreuse (FR)**

(74) Mandataire: **Audier, Philippe André et al**
**Brevalex,**
**3, rue du Docteur Lancereaux**
**75008 Paris (FR)**

(56) Documents cités:
**US-A- 5 363 800**

- **SEMOND F ET AL: "ATOMIC STRUCTURE OF THE BETA-SIC(100)-(3X2)SURFACE" PHYSICAL REVIEW LETTERS, vol. 77, no. 10, 2 septembre 1996, pages 2013-2016, XP000647083 cité dans la demande**
- **SHEN T -C ET AL: "ATOMIC-SCALE DESORPTION THROUGH ELECTRONIC AND VIBRATIONAL EXCITATION MECHANISMS" SCIENCE, vol. 268, no. 5217, 16 juin 1995, pages 1590-1592, XP000647904 cité dans la demande**

## Description

### Domaine technique

La présente invention concerne des fils atomiques de grande longueur et de grande stabilité ainsi qu'un procédé de fabrication de ces fils.

L'invention s'applique tout particulièrement aux domaines de la nano-électronique, de l'optique et de la micromécanique.

### Etat de. la technique antérieure

Divers travaux ont été consacrés à la fabrication de fils atomiques sur les surfaces de métaux ou de semi-conducteurs.

La formation de fils atomiques résulte de processus mettant en jeu les propriétés structurelles, dynamiques et de réactivité des surfaces solides à l'échelle atomique.

Le problème de la fabrication de fils atomiques est aussi étroitement lié à celui de la visualisation de ces fils formés d'atomes.

Compte tenu de leurs dimensions sub-nanométriques (inférieures ou égales à 1 nm), la visualisation et le contrôle de telles nano-structures ne peuvent être réalisés qu'à l'aide d'un microscope à effet tunnel.

Les principales méthodes connues de fabrication de fils atomiques sont indiquées dans ce qui suit.

Une première méthode connue consiste en un dépôt contrôlé d'adsorbat sur une surface solide.

Selon cette première méthode connue, en exploitant les propriétés d'anisotropie des surfaces solides et en contrôlant le flux du dépôt d'adsorbat ainsi que la température du substrat, il est possible de construire des fils atomiques.

La formation de ces fils est fondée soit sur des coefficients de collage anisotrope en surface, soit sur l'anisotropie de certaines structures métastables, soit sur une diffusion anisotrope.

A ce sujet, on consultera les documents (1) à (5) qui, comme les autres documents cités par la suite, sont mentionnés à la fin de la présente description.

Une deuxième méthode connue consiste en une nanolithographie avec la pointe d'un microscope à effet tunnel.

Les électrons issus de cette pointe du microscope à effet tunnel peuvent être utilisés pour produire, à l'échelle nanométrique, une réaction de décomposition ou de désorption.

En déplaçant la pointe du microscope à effet tunnel, on peut ainsi produire des fils atomiques.

A ce sujet, on se reportera au document (6).

On indique ci-après les performances comparées de ces méthodes connues.

La méthode de dépôt contrôlé permet de fabriquer des fils atomiques ayant toute la même direction sur une grande surface.

La composition de ces fils peut être bien définie.

Cependant, cette méthode présente des inconvénients.

En effet, les fils obtenus sont peu stables thermiquement, en raison notamment des substrats ou adsorbats employés.

De plus, la longueur de ces fils atomiques est généralement limitée à quelques dizaines de nanomètres et leur répartition sur la surface est aléatoire et donc non contrôlable.

En outre, il est à noter que lorsque la densité de ces fils sur la surface est grande, un phénomène de coalescence des fils est susceptible de se produire, ce qui conduit non plus à des fils mais à un ensemble bidimensionnel d'atomes.

La deuxième méthode connue, mentionnée plus haut, permet de fabriquer un réseau très régulier de fils atomiques.

La longueur de ces fils peut, potentiellement, être élevée.

Cependant, cette deuxième méthode connue présente les inconvénients suivants.

Les fils atomiques sont de mauvaise qualité à l'échelle atomique.

De plus, seul un petit nombre de fils peut être obtenu par cette méthode.

En outre, cette méthode demande généralement une surface à basse température, inférieure à 0°C.

### Exposé de l'invention

La présente invention a pour but de remédier aux inconvénients précédents.

Elle a tout d'abord pour objet des fils atomiques de grande longueur et de grande stabilité.

L'invention concerne également un procédé de fabrication de ces fils.

Ce procédé est le seul qui permette de produire un réseau régulier de fils atomiques de grande longueur sur une grande surface.

De plus, les fils atomiques fabriqués grâce à ce procédé ont une très grande stabilité thermique, jusqu'à une température de l'ordre de 1000°C, ce qui est sans commune mesure avec la stabilité thermique des 5 fils atomiques obtenus avec les autres procédés connus, qui est de l'ordre de 200°C dans les meilleurs cas.

L'invention repousse donc considérablement les limites de stabilité connues à ce jour pour ce type de sub-nanostructure.

Par ailleurs, contrairement au procédé connu mentionné plus haut, le procédé objet de l'invention permet de contrôler le nombre de lignes ou fils atomiques en permettant d'obtenir des ensembles allant du superréseau de fils atomiques jusqu'à un ensemble limité à un seul fil atomique sur une surface.

De façon précise, la présente invention a pour objet un ensemble de N fils atomiques formés sur la surface d'un substrat en SiC , N étant un nombre entier au moins égal à 1, caractérisé en ce que ces fils sont des chaînes rectilignes de dimères d'un élément choisi parmi Si et C, ces chaînes étant parallèles les unes aux autres et sensiblement équidistantes les unes des autres, s'étendant d'un bout à l'autre du substrat et étant perpendiculaires à la direction des dimères.

Selon un premier mode de réalisation particulier de cet ensemble, ladite surface est une surface de $\beta$-SiC (100) terminée Si, lesdites chaînes étant des chaînes de dimères Si-Si.

Selon un deuxième mode de réalisation particulier, ladite surface est une surface de $\beta$-SiC (100) terminée C, lesdites chaînes étant des chaînes de dimères C-C.

La présente invention concerne également un procédé de fabrication de l'ensemble de N fils atomiques objet de l'invention, caractérisé en ce qu'on forme des couches dudit élément sur ladite surface et on construit ledit ensemble au moyen de recuits de cette surface munie desdites couches, le dernier recuit étant apte à éliminer progressivement de cette surface, de façon sélective, des rangées de dimères dudit élément de manière à obtenir ledit ensemble de N fils atomiques.

On peut choisir la température et la durée du dernier des recuits pour obtenir un nombre N souhaité de fils atomiques sur une longueur donnée, comptée perpendiculairement aux fils.

De préférence, ledit ensemble est construit dans une enceinte maintenue à une pression inférieure à $5\times10^{-9}$ Pa ou sous atmosphère neutre.

Selon un mode de mise en oeuvre préféré du procédé objet de l'invention, on forme un substrat monocristallin de SiC en phase cubique $\beta$-SiC (100), on transforme ce substrat pour que sa surface soit terminée Si et reconstruite 3x2 et on recuit le substrat ainsi transformé à une température choisie dans l'intervalle allant de 1000°C à 1150°C de manière à éliminer progressivement de cette surface, par désorption sélective, des rangées de dimères Si-Si et à obtenir ledit ensemble de N fils atomiques.

Le temps pendant lequel on recuit le substrat ainsi transformé dépend des caractéristiques géométriques du substrat. Ce temps peut être choisi dans un intervalle allant de 5 minutes à 10 minutes.

Ledit substrat monocristallin peut être obtenu par dépôt chimique en phase vapeur d'un premier composé gazeux contenant du carbone et d'un deuxième composé gazeux contenant du silicium sur une surface vicinale de Si (100) désorientée de 4°.

Le premier composé gazeux peut être $C_3H_8$ et le deuxième composé gazeux peut être $SiH_4$.

De préférence, on recuit ledit substrat monocristallin pour que sa surface devienne une surface de structure 1x1 riche en carbone, on dépose des couches de silicium sur cette surface à température ambiante puis on recuit le substrat muni de ces couches de silicium à environ 1000°C pour obtenir une surface de $\beta$-SiC (100) terminée Si et reconstruite 3x2.

La présente invention a de nombreuses applications.

On indique dès à présent qu'elle s'applique à la fabrication d'un ensemble de fils d'une matière métallique, magnétique, polymérique, organique, semiconductrice, isolante ou biologique, en utilisant ledit ensemble de N fils atomiques en tant que matrice recevant un dépôt de ladite matière.

La présente invention s'applique également à l'adressage parallèle de dispositifs électroniques dont la taille est de l'ordre de 0,1 nm à 10 nm, les fils atomiques ayant une épaisseur de l'ordre de 0,1 nm à 10 nm.

Les fils atomiques objets de l'invention diffèrent de ce qui a été proposé dans l'art antérieur à la fois par le procédé de fabrication et par la nature du produit obtenu.

En effet, le choix du substrat, le procédé utilisé et la qualité des fils obtenus sont très différents de ce qu'enseigne l'art antérieur.

En ce qui concerne le choix du substrat, les fils atomiques obtenus le sont sur la surface d'un matériau semiconducteur réfractaire, le carbure de silicium, de préférence dans sa phase cubique $\beta$-SiC.

Le carbure de silicium est un matériau ayant de très bonnes caractéristiques, à savoir une grande stabilité thermique, une grande stabilité chimique, une capacité de supporter des environnements très hostiles (hautes températures, rayonnements ionisants, milieux chimiques agressifs).

C'est aussi une céramique ayant une grande dureté (qui est proche de celle du diamant et de celle du carbure de bore).

Enfin, c'est l'un des meilleurs matériaux biocompatibles connus.

On a en particulier vérifié que les fils de silicium fabriqués sur le $\beta$-SiC (100) sont très stables thermiquement, jusqu'à environ 1000°C, et chimiquement.

Dans les méthodes connues, les substrats utilisés sont le Si (100) ou des surfaces de métaux monocristallins comme par exemple Pt (110) ou Au (100).

Dans tous les cas, les fils atomiques sont instables thermiquement.

Dans le cas du procédé de dépôt contrôlé, cette instabilité est inhérente au procédé lui-même qui repose sur la dépendance de la diffusion de surface avec la température.

Dans le cas du procédé nanolithographique avec un microscope à effet tunnel, l'instabilité provient du choix du matériau (H/Si par exemple) qui est instable à partir d'une température de l'ordre de 300°C à 400°C.

Les procédés fondés sur le contrôle de la diffusion de surface en fonction de la température permettent seulement de produire des fils atomiques qui ne sont stables qu'à une seule température et qui se modifient quand la température change.

Dans la présente invention, on utilise de préférence un procédé fondé sur la désorption sélective à haute température, entre 1000°C et 1150°C.

Le contrôle de la densité des fils atomiques est assuré par le contrôle de la température de surface.

Une fois réalisés, ces fils sont très stables en dessous de 1000°C.

En ce qui concerne la qualité des fils atomiques obtenus, notamment sur le β-SiC (100), on précise que ces fils atomiques ont des caractéristiques uniques qui ne peuvent être obtenues par d'autres procédés.

La longueur de ces fils atomiques n'est limitée que par le substrat sur lequel on les forme.

Ces fils atomiques sont tous parallèles, ont de bonnes qualités à l'échelle atomique et peuvent former des réseaux dont on peut contrôler la densité.

Ces fils sont très stables chimiquement et surtout thermiquement jusqu'à environ 1000°C.

**Brève description des dessins**

La présente invention sera mieux comprise à la lecture de la description d'exemples de réalisation donnés ci-après, à titre purement indicatif et nullement limitatif, en faisant référence aux dessins annexés sur lesquels :

- la figure 1 est une vue de dessus schématique d'un ensemble de fils atomiques conforme à l'invention et de grande densité (super-réseau),
- la figure 2 est une vue de dessus schématique d'un autre ensemble de fils atomiques conforme à l'invention, de densité plus faible,
- la figure 3 est une vue de dessus schématique d'un fil atomique isolé conforme à l'invention (N=1),
- la figure 4 est une vue en coupe schématique d'une surface de β-SiC (100) terminée Si et reconstruite 3x2,
- la figure 5 est une vue de dessus schématique de la figure 4,
- la figure 6 est une vue en coupe schématique d'une surface de β-SiC (100), terminée c (4x2),
- la figure 7 est une vue de dessus schématique de la figure 6,
- les figures 8 et 9 sont des vues en coupe schématiques de surfaces de β-SiC (100), terminées Si et reconstruites nx2, n étant un nombre impair supérieur à 3, et
- la figure 10 illustre schématiquement une application de l'invention à l'adressage parallèle de nano-objets.

**Exposé détaillé de modes de réalisation particuliers**

L'invention concerne donc des lignes ou fils atomiques de grande longueur, formés sur la surface d'un substrat en carbure de silicium.

On est capable de faire varier les distances entre les fils atomiques de manière contrôlée, de 1 nm à plusieurs millimètres.

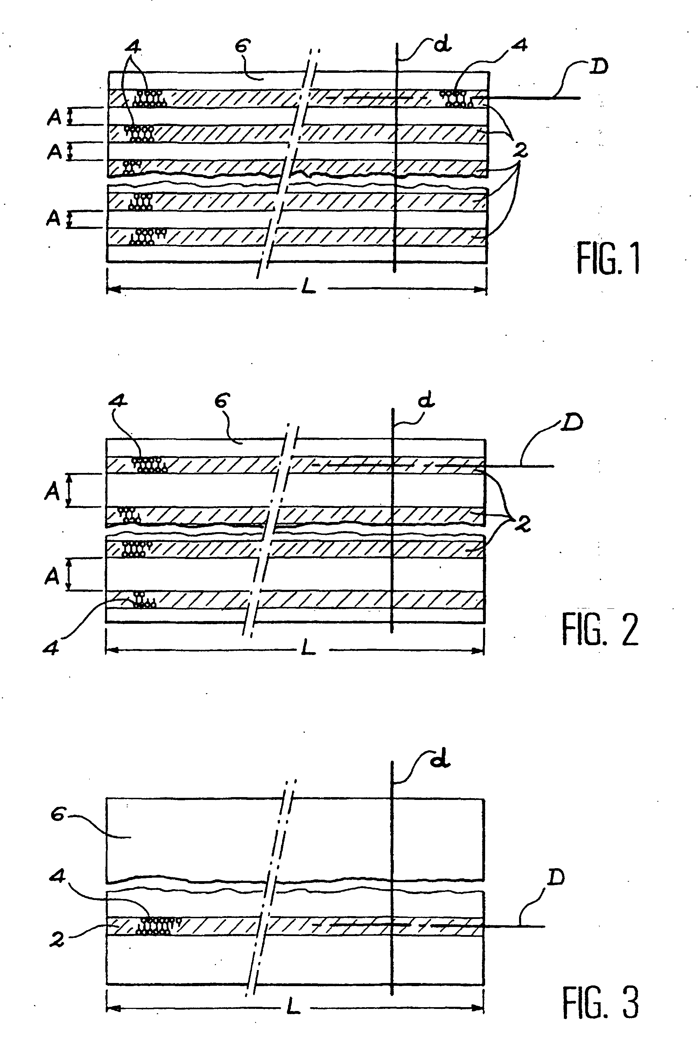

Ceci est schématiquement illustré en vue de dessus par les figures 1 à 3.

On voit sur les figures 1 et 2 des fils atomiques 2 qui sont des chaînes de dimères de silicium (Si-Si) référencés 4, sont très rectilignes et ont tous la même direction D.

Leur longueur L est très grande (supérieure à 100 nm) et n'est limitée que par la longueur du substrat 6 sur lequel ces fils 2 sont formés.

Ces fils sont régulièrement espacés les uns des autres.

Ils s'étendent perpendiculairement à la direction d des dimères.

On est capable de faire varier le nombre N de fils atomiques avec la température pour passer d'un super-réseau de fils atomiques, qui sont séparés les uns des autres d'une distance de l'ordre de quelques dixièmes de nanomètres (figure 1), à un ensemble de fils atomiques qui sont séparés les uns des autres d'une distance A de l'ordre de quelques nanomètres (figure 2) et même passer de cet ensemble à un seul fil atomique isolé 2 qui est séparé d'autres fils atomiques (non représentés) d'une distance de plusieurs dizaines de nanomètres (figure 3).

On a dessiné sur les figures 1 à 3 les dimères 4 et l'on voit bien que la direction D des fils atomiques est perpendiculaire à la direction d de ces dimères 4, cette direction d étant donnée par la ligne droite qui passe par les centres des deux atomes de silicium appartenant au même dimère.

Comme on l'a vu plus haut, ces fils atomiques sont stables jusqu'à une température de l'ordre de 1000°C.

On explique ci-après un procédé de fabrication des fils atomiques en silice du genre de ceux des figures 1 à 3.

On part d'une surface β-SiC (100) terminée Si et reconstruite 3x2.

La préparation d'une telle surface est décrite dans les documents (7) et (8) auxquels on se reportera.

A partir de cette surface, on passe à une autre reconstruction de surface, la c(4x2), par désorption thermique du silicium.

A ce sujet, on consultera le document (7).

Les états qui nous intéressent dans la présente invention sont ceux qui apparaissent entre ces deux reconstructions de surface.

Les rangées de dimères de silicium sont éliminées progressivement de la surface reconstruite 3x2, par recuit à des températures comprises entre 1000°C et 1150°C et pendant des temps variables allant d'environ 5 minutes à 10 minutes.

Les fils atomiques qui font l'objet de l'invention apparaissent à la transition de phase entre la reconstruction 3x2 et la reconstruction c(4x2).

Le nombre N de fils atomiques et l'espacement A entre ceux-ci dépendent de la température et de la durée de ce recuit.

La fabrication des fils atomiques est effectuée dans une enceinte étanche (non représentée), maintenue à une pression inférieure à $5 \times 10^{-9}$ Pa.

Le substrat de carbure de silicium utilisé est de préférence un film monocristallin très mince, d'une épaisseur de l'ordre de 1 μm, de carbure de silicium en phase cubique β-SiC (100).

Il est obtenu par dépôt chimique en phase vapeur (ou CVD) de $C_3H_8$ et de $SiH_4$ sur une surface vicinale de Si (100) désorientée de 4°.

On peut aussi utiliser, en tant que substrat, un monocristal de SiC massif.

A ce sujet, on consultera les documents (9), (10) et (11).

Ensuite, le substrat monocristallin de carbure de silicium en phase cubique β-SiC (100) est soumis à une succession de recuits qui permet d'éliminer de la surface du substrat des oxydes natifs de silicium et du carbone résultant du procédé de fabrication CVD, ce qui conduit à une structure de surface 1x1 riche en carbone.

On dépose ensuite successivement des couches (au moins deux) de silicium à température ambiante (de l'ordre. de 20°C) sur cette surface.

Puis on effectue des recuits du substrat résultant à environ 1000°C.

Ceci conduit à une surface plane de β-SiC (100) terminée Si, c'est-à-dire riche en silicium, et ayant la reconstruction de surface 3x2.

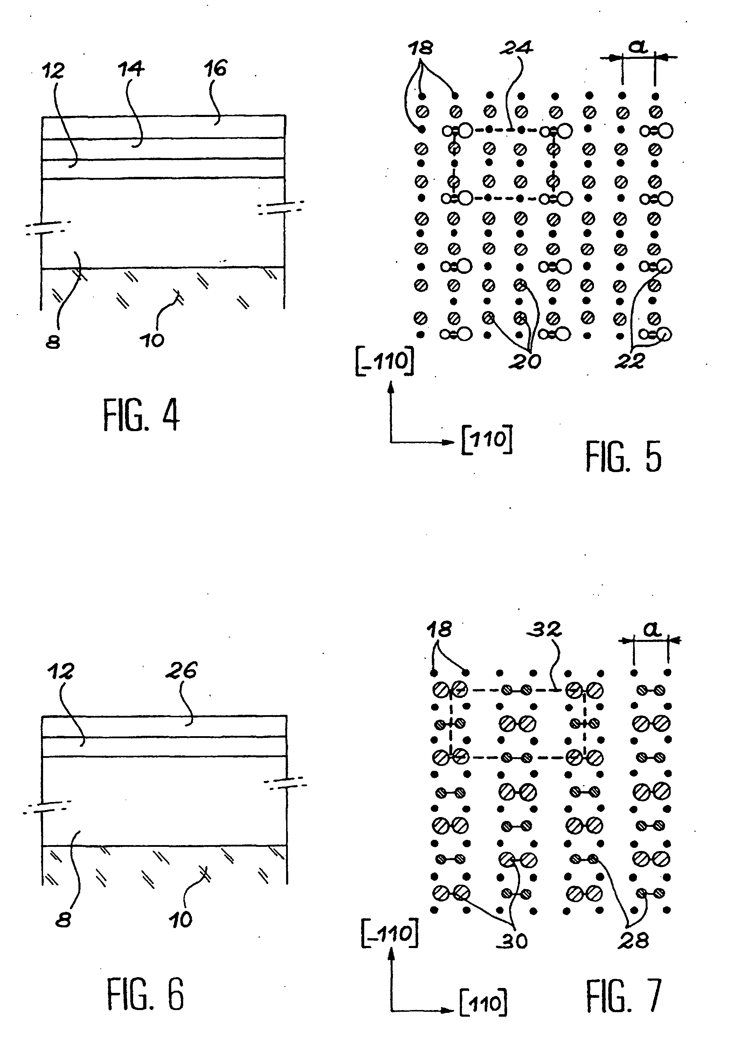

La figure 4 est une vue en coupe transversale schématique du substrat de β-SiC (100) dont la surface est terminée Si et reconstruite 3x2.

On voit sur cette figure 4, le film très mince de carbure de silicium monocristallin 8 formé sur une plaquette 10 de Si (100).

La surface de ce substrat 8 est formée par une monocouche de carbone 12.

Cette monocouche de carbone 12 est elle-même recouverte par une monocouche de silicium 14.

Cette monocouche de silicium 14 est recouverte par une monocouche dépeuplée 16 d'atomes de silicium, qui constitue un tiers de monocouche de silicium.

La figure 5 est une vue de dessus du substrat muni des monocouches 12 et 14 et de la monocouche dépeuplée 16.

On voit l'agencement des atomes de carbone 18 de la couche 12 au-dessus desquels se trouvent les atomes de silicium 20 de la monocouche de silicium 14.

On voit également des dimères asymétriques Si-Si référencés 22, l'ensemble de ces dimères 22 constituant la monocouche de silicium dépeuplée 16.

Dans cette couche 16, qui constitue la couche supérieure du substrat, les dimères asymétriques 22 ont tous le même angle d'inclinaison et l'on voit bien que les rangées de dimères sont perpendiculaires à la direction des dimères.

Pour chaque dimère 22, l'atome supérieur de silicium est représenté avec un cercle plus grand que celui de l'atome inférieur de silicium.

Sur la figure 5, le rectangle 24 en pointillés représente la maille élémentaire de la surface reconstruite 3x2.

La distance a est égale à $a_0/\sqrt{2}$, $a_0$ étant le paramètre de maille de β-SiC en volume.

On a également noté les directions [110] et [-110] du β-SiC (100).

La figure 6 est une vue en coupe transversale schématique du substrat dont la surface est reconstruite c (4x2), cette reconstruction étant obtenue par recuit du substrat de la figure 4.

On voit encore la plaquette de silicium 10, le film 8 de carbure de silicium et la monocouche de carbone 12.

On voit aussi une monocouche de silicium 26 qui est un réarrangement de la monocouche 14 de la figure 4, la monocouche dépeuplée 16 ayant disparu.

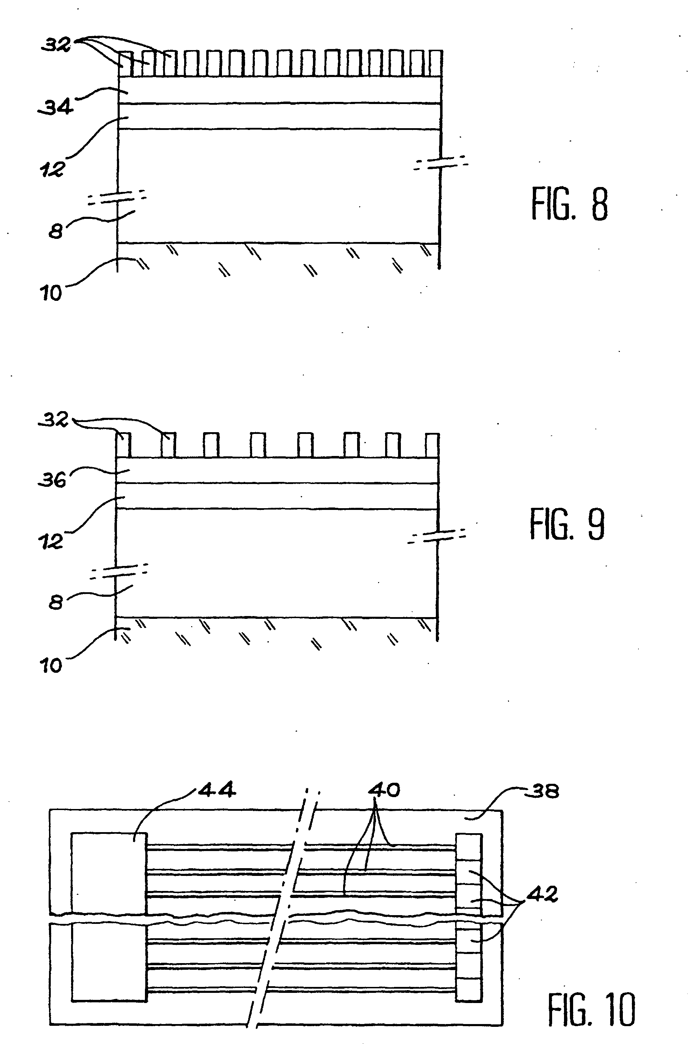

La figure 7 est une vue de dessus du substrat muni de ces couches 12 et 26.

On voit encore sur la figure 7 les atomes 18 de la monocouche de carbone 12.

On voit aussi les atomes de la monocouche de silicium 26.

Ces atomes forment aussi des dimères Si-Si.

On distingue les dimères Si-Si inférieurs qui sont référencés 28 et les dimères Si-Si supérieurs qui sont référencés 30 et représentés par des cercles plus gros que ceux des dimères inférieurs.

Sur la figure 7, le rectangle en pointillés 32 représente la maille élémentaire de la surface reconstruite c (4x2) du β-SiC (100).

La figure 8 est une vue en coupe transversale schématique illustrant une phase intermédiaire entre les phases des figures 4 et 6.

Cette phase intermédiaire correspond à une reconstruction de type nx2 où n est un nombre impair supérieur à 3 et par exemple égal à 5.

La phase intermédiaire de la figure 8 est obtenue par recuit de la structure de la figure 4 et porte, à sa surface supérieure, des fils atomiques 32 conformes à l'invention.

Ceux-ci résultent d'une modification de la monocouche dépeuplée 16 de la figure 4, modification qui est due au recuit.

On voit également sur la figure 8 une monocouche de silicium 34 résultant d'une réorganisation de la couche 14 de la figure 4 sous l'effet du recuit.

A partir de cette phase représentée sur la figure 8, on passe encore, par un recuit, à une autre phase intermédiaire (correspondant aussi à une reconstruction de type nx2 où n est par exemple égal à 7) où les fils atomiques 32 sont plus espacés les uns des autres comme l'illustre schématiquement la figure 9.

On voit également sur la figure 9 une monocouche de silicium 36 qui résulte d'une réorganisation de la couche 34 de la figure 8 sous l'effet du recuit.

Il est à noter qu'un recuit supplémentaire permet de passer de la structure représentée sur la figure 9 à la structure représentée sur la figure 6.

La présente invention n'est pas limitée à des fils atomiques de silicium.

Elle concerne aussi des fils atomiques de carbone, constitués par des agencements de dimères C-C.

On peut obtenir de tels fils atomiques de carbone en utilisant une approche identique à celle utilisée pour le fils de silicium.

Les fils atomiques objets de l'invention ont de nombreuses applications.

On indique tout d'abord que le carbure de silicium est un composé semiconducteur IV-IV très intéressant.

En effet, ce matériau a de nombreuses applications pratiques en micro-électronique (pour les hautes fréquences, les hautes températures, les hautes tensions et les hautes puissances) et en optoélectronique.

De plus, du fait de ses grandes stabilités thermique et chimique, le carbure de silicium est un matériau très attrayant pour fonctionner dans des environnements hostiles du genre de ceux que l'on rencontre en aéronautique, dans l'industrie spatiale, l'industrie automobile et l'industrie pétrolière, en géophysique et dans les réacteurs nucléaires.

En outre, le carbure de silicium est une céramique qui a de très intéressantes propriétés mécaniques, comme par exemple une grande dureté, et il est l'un des meilleurs matériaux biocompatibles notamment avec les cellules sanguines.

On indique tout d'abord une première application des fils atomiques objets de l'invention.

Des réseaux de fils atomiques conformes à l'invention peuvent être utilisés comme matrices pour la fabrication de réseaux analogues de fils métalliques, magnétiques ou polymériques.

Pour ce faire, on dépose sur un substrat portant un réseau de fils atomiques conformes à l'invention une matière métallique, magnétique, polymérique, organique, semi-conductrice, isolante ou biologique pour obtenir un réseau analogue de fils métalliques, magnétiques, polymériques, organiques, semi-conducteurs, isolants ou biologiques.

L'invention trouve également des applications en électronique.

La recherche d'une miniaturisation en électronique a conduit à la fabrication de dispositifs élémentaires de plus en plus petits qui peuvent atteindre 0,2 $\mu$m ou 0,3 $\mu$m.

Cependant, grâce aux nouvelles méthodes de manipulation individuelle d'atomes et de molécules, on peut maintenant envisager de construire des dispositifs encore plus petits, dont la taille peut aller de 0,1 nm à 10 nm.

Dans ce domaine, on cherche à réaliser des fonctions élémentaires pour l'électronique avec des nano-objets ayant cette taille.

Un problème difficile à résoudre concerne l'adressage de ces nano-objets.

Cet adressage nécessite des fils d'épaisseur également très petite, de l'ordre de 0,1 nm à 10 nm, et doit pouvoir s'effectuer de manière parallèle sur un très grand nombre (pouvant aller jusqu'à plusieurs millions) de nano-objets.

L'invention permet de résoudre ce problème au moyen d'un réseau de fils atomiques obtenus par exemple sur le $\beta$-SiC (100), ce réseau de fils atomiques constituant en quelque sorte un circuit imprimé à l'échelle nanométrique.

On peut ajuster la distance entre les fils atomiques à partir de 1 nm environ.

La figure 10 illustre schématiquement l'adressage parallèle mentionné plus haut.

On voit sur cette figure 10 un substrat 38 sur lequel sont formés des fils atomiques parallèles 40 conformément à l'invention.

Ces fils 40 permettent l'adressage parallèle de dispositifs nano-électroniques 42 qui sont formées sur le substrat 38.

Un dispositif micro-électronique 44 également formé sur ce substrat 38 envoie des signaux de commande aux dispositifs 42 par l'intermédiaire des fils 40.

On mentionne également que les fils atomiques de silicium formés sur une surface de $\beta$-SiC (100) conformément à l'invention trouvent également un intérêt dans la réalisation d'écluses à électrons.

On peut également envisager le greffage, sur des fils atomiques conformes à l'invention ou entre ces fils, d'atomes de métaux ou d'atomes d'oxygène pour la passivation ou encore de molécules organiques ou inorganiques.

On peut également envisager de découper de manière contrôlée, avec la pointe d'un microscope à effet tunnel, des morceaux de fils atomiques conformes à l'invention, afin d'assurer de manière flexible les connexions entre les différents nano-objets.

L'invention trouve également des applications en optique.

L'invention permet la réalisation d'un réseau nanométrique de champ électromagnétique ayant les mêmes caractéristiques géométriques (longueurs et distances interlignes) qu'un réseau de fils atomiques conformes à l'invention.

En effet, l'éclairage de ce réseau par un faisceau lumineux approprié est capable, localement, près de la surface où se trouve ce réseau, de produire une distribution de champ électromagnétique proche tout à fait originale, épousant la même répartition spatiale que les fils atomiques.

Ce réseau nanométrique de champ électromagnétique trouve des applications dans le dépôt assisté par laser de nano-structures atomiques sur une surface.

L'invention trouve encore des applications dans le domaine de la micromécanique.

Les propriétés tribologiques de surfaces portant des fils atomiques conformes à l'invention sont très anisotropes, ce qui les rend utiles dans les dispositifs micromécaniques impliquant des déplacements.

Les documents cités dans la présente description sont les suivants :

(1)H. Rôder, E. Hahn, H. Brune, J.P. Bucher et K. Kern, **Nature 366,** 141 (1993).

(2)S. Günther et al., **Phys. Rev. Lett. 73,** 553 (1994).

(3)H. Itoh, J. Itoh, A. Schmid et T. Ichinokawa, **Phys. Rev. B 48,** 14663 (1993).

(4) J.A. Yoshikawa, J. Nogami, C.F. Quate et P. Pianetta, **Surf. Sci. 321,** 2183 (1994).

(5)Y.W. Mo, J. Klein, M.B. Webb et M.G. Lagally, **Surf. Sci. 268,** 275 (1992).

(6)T.C. Shen, C. Wang, G.L. Abeln, J.R. Tucker, J. W. Lyding, Ph. Avouris et R.E. Walkup, **Science 268,** 1590 (1995).

(7) R. Kaplan et V.M. Bermudez, in Properties of Silicon Carbide, G. Harris Editor, EMIS **Datareview Series,** INSPEC (London), vol. 13, 101 (1995).

(8) F. Semond, P. Soukiassian, A. Mayne, G. Dujardin, L. Douillard et C. Jaussaud, Phys. **Rev. Lett. 77**, 2013 (1996).

(9)M. Riehl-Chudoba, P. Soukiassian et C. Jaussaud, J. **Appl. Phys. 76,** 1332 (1994).

(10)M. Riehl-Chudoba, S. Dupont et P. Soukiassian, **Surf. Sci. 331-333,** 625 (1995).

(11)M. Riehl-Chudoba, P. Soukiassian, C. Jaussaud et S. Dupont, **Phys. Rev. B 51,** 14300 (1995).

**Revendications**

1. Ensemble de N fils atomiques formés sur la surface d'un substrat (6, 38) en SiC N étant un nombre entier au moins égal à 1, **caractérisé en ce que** ces fils (2, 40) sont des chaînes rectilignes de dimères (4) d'un élément choisi parmi Si et C, ces chaînes étant parallèles les unes aux autres et sensiblement équidistantes les unes des autres, s'étendant d'un bout à l'autre du substrat et étant perpendiculaires à la direction des dimères.

2. Ensemble de N fils atomiques selon la revendication 1, dans lequel ladite surface est une surface de $\beta$-SiC (100) terminée Si, lesdites chaînes étant des chaînes de dimères Si-Si.

3. Ensemble de N fils atomiques selon la revendication 1, dans lequel ladite surface est une surface de $\beta$-SiC (100) terminée C, lesdites chaînes étant des chaînes de dimères C-C.

4. Procédé de fabrication de l'ensemble de N fils atomiques selon la revendication 1, ce procédé comprenant les étapes suivantes: on forme des couches (14, 16) dudit élément sur ladite surface et on construit ledit ensemble au moyen de recuits de cette surface munie desdites couches, le dernier recuit étant apte à éliminer progressivement de cette surface, de façon sélective, des rangées de dimères dudit élément de manière à obtenir ledit ensemble de N fils atomiques.

5. Procédé selon la revendication 4, dans lequel on choisit la température et la durée du dernier des recuits pour obtenir un nombre N souhaité de fils atomiques sur une distance donnée, comptée perpendiculairement aux fils.

6. Procédé selon l'une quelconque des revendications 4 et 5, dans lequel ledit ensemble est construit dans une enceinte maintenue à une pression inférieure à $5 \times 10^{-9}$ Pa ou sous atmosphère neutre.

7. Procédé selon l'une quelconque des revendications 4 à 6, dans lequel on forme un substrat monocristallin (8) de SiC en phase cubique $\beta$-SiC (100), on transforme ce substrat pour que sa surface soit terminée Si et reconstruite 3x2 et on recuit le substrat ainsi transformé à une température choisie dans l'intervalle allant de 1000°C à 1150°C de manière à éliminer progressivement de cette surface, par désorption sélective, des rangées de dimères Si-Si et à obtenir ledit ensemble de N fils atomiques.

8. Procédé selon la revendication 7, dans lequel on recuit le substrat ainsi transformé pendant un temps choisi dans l'intervalle allant de 5 minutes à 10 minutes.

9. Procédé selon la revendication 7, dans lequel ledit substrat monocristallin (8) est obtenu par dépôt chimique en phase vapeur d'un premier composé gazeux contenant du carbone et d'un deuxième composé gazeux contenant du silicium sur une surface vicinale de Si (100) désorientée de 4°.

10. Procédé selon la revendication 9, dans lequel le premier composé gazeux est $C_3H_8$ et le deuxième composé gazeux est $SiH_4$.

11. Procédé selon l'une quelconque des revendications 9 et 10, dans lequel on recuit ledit substrat monocristallin (8) pour que sa surface devienne une surface de structure 1x1 riche en carbone, on dépose des couches de silicium sur cette surface à température ambiante puis on recuit le substrat muni de ces couches de silicium à environ 1000°C pour obtenir une surface de β-SiC (100) terminée Si et reconstruite 3x2.

12. Application de l'ensemble de N fils atomiques selon l'une quelconque des revendications 1 à 3 à la fabrication d'un ensemble de fils d'une matière métallique, magnétique, polymérique, organique, semiconductrice, isolante ou biologique, en utilisant ledit ensemble de N fils atomiques en tant que matrice recevant un dépôt de ladite matière.

13. Application de l'ensemble de N fils atomiques selon l'une quelconque des revendications 1 à 3 à l'adressage parallèle de dispositifs électroniques (42) dont la taille est de L'ordre de 0,1 nm à 10 nm, les fils atomiques (40) ayant une épaisseur de l'ordre de 0,1 nm à 10 nm.

**Claims**

1. A set of N atomic wires formed on the surface of a SiC substrate (6, 38), N being an integer number equal to at least 1, **characterized in that** these wires (2, 40) are straight chains of dimers (4) of an element chosen from amongst Si and C, these chains being parallel to each other and substantially equidistant from each other, extending from one end of the substrate to another and being perpendicular to the direction of the dimers.

2. A set of N atomic wires according to claim 1, in which the said surface is a surface of Si-terminated β-SiC (100), the said chains being chains of Si-Si dimers.

3. A set of N atomic wires according to claim 1, in which the said surface is a C-terminated β-SiC (100) surface, the said chains being chains of C-C dimers.

4. A method of manufacturing the set of N atomic wires formed on the surface of a SiC substrate (6, 38) according to claim 1, said method comprising the following stages:

   layers (14, 16) of the said element are formed on the said surface and the said set is constructed by means of annealings of the surface provided with the said layers, the last annealing being able to eliminate progressively from the surface, selectively, rows of dimers of said elements so as to obtain the said set of N atomic wires.

5. A method according to claim 4, in which the temperature and duration of the last of the annealings is chosen so as to obtain a required number N of atomic wires over a given distance, counted perpendicularly to the wires.

6. A method according to either one of Claims 4 and 5, in which the said set is constructed in a chamber maintained at a pressure below $5x10^{-9}$ Pa or in a neutral atmosphere.

7. A method according to any one of Claims 4 to 6, in which a monocrystalline substrate (8) is formed of SiC in β-SiC (100) cubic phase, this substrate is transformed so that its surface is Si terminated and 3x2 reconstructed and the substrate thus transformed is annealed at a temperature chosen in the range from 1000°C to 1150 °C so as to progressively eliminate rows of Si-Si dimers from this surface by selective desorption and to obtain the said set of N a/$_{omic}$ wires.

8. A method according to Claim 7, in which the substrate thus transformed is annealed for a time chosen in the range from 5 minutes to 10 minutes.

9. A method according to Claim 7, in which the said monocrystalline substrate (8) is obtained by chemical vapour deposition of a first gaseous compound containing carbon and a second gaseous compound containing silicon on a vicinal surface of Si (100) deorientated by 4°.

10. A method according to Claim 9, in which the first gaseous compound is $C_3H_8$ and the second gaseous compound is $SiH_4$.

11. A method according to either one of Claims 9 and 10, in which the said monocrystalline substrate (8) is annealed so that its surface becomes a surface with a carbon-rich 1x1 structure, layers of silicon are deposited on this surface at room temperature and then the substrate provided with these silicon surfaces is annealed at approximately 1000°C in order to obtain a surface of Si-terminated and 3x2 reconstructed β-SiC (100).

12. Application of the set of N atomic wires according to any one of Claims 1 to 3 to the manufacture of a set of wires of a metallic, magnetic, polymeric, organic, semiconducting, insulating or biological material, using the said set of N atomic wires as a matrix receiving a deposit of the said material.

13. Application of the set of N atomic wires according to any one of Claims 1 to 3 to the parallel addressing of electronic devices (42) whose size is around 0.1 nm to 10 nm, the atomic wires (40) having a thickness of around 0.1 nm to 10 nm.

## Patentansprüche

1. System aus N atomaren Drähten, ausgebildet auf der Oberfläche eines SiC-Substrats (6, 38), wobei N eine ganze Zahl und wenigstens gleich 1 ist, **dadurch gekennzeichnet, dass** diese Drähte (2, 40) geradlinige Ketten von Dimeren (4) eines zwischen Si und C ausgewählten Elements sind, parallel und im Wesentlichen äquidistant zueinander, die sich von einem Ende des Substrats zum anderen erstrecken und senkrecht sind zu der Richtung der Dimere.

2. System aus N atomaren Drähten nach Anspruch 1, bei dem die genannte Oberfläche eine Si-fertiggestellt bzw. Si-reiche β-SiC(100)-Oberfläche ist, wobei die genannten Ketten Si-Si-Dimer-Ketten sind.

3. System aus N atomaren Drähten nach Anspruch 1, bei dem die genannte Oberfläche eine C-fertiggestellt bzw. C-reiche β-SiC(100)-Oberfläche ist, wobei die genannten Ketten C-C-Dimer-Ketten sind.

4. Herstellungsverfahren des Systems aus N atomaren Drähten, ausgebildet auf der Oberfläche eines SiC-Substrats (6, 38) nach Anspruch 1, wobei dieses Verfahren die folgenden Schritte umfasst: man erzeugt Schichten (14, 16) des genannten Elements auf der genannten Oberflächen und man realisiert das genannte System, indem man die mit diesen Schichten versehene Oberfläche mehrmals tempert, wobei das letzte Tempern fähig ist, auf selektive Weise Reihen von Dimeren des genannten Elements progressiv so zu eliminieren, dass man das genannte System aus N atomaren Drähten erhält.

5. Verfahren nach Anspruch 4, bei dem man die Temperatur und die Dauer des letzten Temperns so wählt, dass man über eine bestimmte Distanz eine gewünschte, senkrecht zu den Drähten gezählte Anzahl N atomarer Drähte erhält,.

6. Verfahren nach einem der Ansprüche 4 und 5, bei dem das genannte System in einem Behälter hergestellt wird, in dem ein Druck unter $5 \times 10^{-9}$ Pa oder eine neutrale Atmosphäre herrscht.

7. Verfahren nach einem der Ansprüche 4 bis 6, bei dem man ein monokristallines SiC-Substrat (8) in kubischer β-SiC(100)-Phase bildet, dieses Substrat so überführt bzw. umsetzt, dass seine Oberfläche Si-fertiggestellt bzw. Si-reich und 3x2 wiederhergestellt wird, und man das derart überführte bzw. umgesetzte Substrat mit einer Temperatur tempert, die in dem von 1000°C bis 1150°C gehenden Intervall gewählt wird, um aus dieser Oberfläche durch selektive Desorption Si-Si-Dimer-Reihen zu eliminieren und das genannte System aus N atomaren Drähten herzustellen.

8. Verfahren nach Anspruch 7, bei dem man das derart umgesetzte bzw. überführte Substrat während einer Zeit tempert, die in dem von 5 Minuten bis 10 Minuten gehenden Intervall gewählt wird.

9. Verfahren nach Anspruch 7, bei dem man das genannte monokristalline Substrat (8) durch chemische Gasphasenabscheidung einer ersten, Kohlenstoff enthaltenden gasförmigen Verbindung und einer zweiten, Silicium enthaltenden gasförmigen Verbindung auf einer um 4° unausgerichteten vicinalen Si(100)-Oberfläche herstellt.

10. Verfahren nach Anspruch 9, bei dem man die erste gasförmige Verbindung $C_3H_8$ ist und die zweite gasförmige Verbindung $SiH_4$ ist.

11. Verfahren nach einem der Ansprüche 9 und 10, bei dem man das genannte monokristalline Substrat (8) tempert, so dass seine Oberfläche eine kohlenstoffreiche 1x1-Struktur wird, man Siliciumschichten auf dieser Oberfläche bei Umgebungstemperatur abscheidet und man das mit diesen Siliciumschichten versehene Substrat bei ungefähr 1000°C tempert, um eine β-SiC(100)-Schicht zu erhalten, Si-fertiggestellt bzw. Si-reich und 3x2 wiederhergestellt.

12. Anwendung des Systems aus N atomaren Drähten nach einem der Ansprüche 1 bis 3 zur Herstellung eines Systems mit Drähten aus einem metallischen, magnetischen, polymeren, organischen, halbleitenden, isolierenden oder biologischen Material, indem das genannte System aus N atomaren Drähten als Matrix benutzt wird, die eine Abscheidung des genannten Materials erhält bzw. aufnimmt.

13. Anwendung des Systems aus N atomaren Drähten nach einem der Ansprüche 1 bis 3 zur parallelen Adressierung elektronischer Vorrichtungen (42), deren Größe 0,1 nm bis 10 nm beträgt, wobei die atomaren Drähte (40) eine Dicke in der Größenordnung von 0,1 nm bis 10 nm haben.

FIG. 1

FIG. 2

FIG. 3

FIG. 4

FIG. 5

FIG. 6

FIG. 7

FIG. 8

FIG. 9

FIG. 10